(19) Europäisches Patentamt
European Patent Office
Office européen des brevets

(11) **EP 2 894 665 B1**

(12) **FASCICULE DE BREVET EUROPEEN**

(45) Date de publication et mention
de la délivrance du brevet:
**28.10.2020 Bulletin 2020/44**

(51) Int Cl.:
***H01L 21/8238*** *(2006.01)*

(21) Numéro de dépôt: **15150205.1**

(22) Date de dépôt: **06.01.2015**

(54) **Procédé de fabrication d'un dispositif microélectronique**

Herstellungsverfahren einer mikroelektronischen Vorrichtung

Method for manufacturing a microelectronic device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.01.2014 FR 1450128**

(43) Date de publication de la demande:
**15.07.2015 Bulletin 2015/29**

(73) Titulaire: **COMMISSARIAT À L'ÉNERGIE ATOMIQUE ET AUX ÉNERGIES ALTERNATIVES
75015 Paris (FR)**

(72) Inventeurs:
• **Fournier, Claire
30130 Pont-Saint-esprit (FR)**
• **Gaillard, Frédéric-Xavier
38500 VOIRON (FR)**
• **Nemouchi, Fabrice
38430 MOIRANS (FR)**

(74) Mandataire: **Decobert, Jean-Pascal
Cabinet Hautier
20, rue de la Liberté
06000 Nice (FR)**

(56) Documents cités:
**US-A1- 2004 137 670     US-A1- 2005 156 208
US-A1- 2006 121 664     US-A1- 2009 315 185
US-A1- 2013 285 153**

• **ROSSER P ET AL: "Silicides for VLSI interconnects", VACUUM, PERGAMON PRESS, GB, vol. 35, no. 10-11, octobre 1985 (1985-10), pages 419-434, XP025751299, ISSN: 0042-207X, DOI: 10.1016/0042-207X(85)90361-6 [extrait le 1985-10-01]**

**Description**

DOMAINE TECHNIQUE DE L'INVENTION

La présente invention concerne un procédé de fabrication de dispositifs microélectroniques de types différents sur une même plaque et, plus particulièrement, un procédé permettant de former des couches métalliques identiques ou différentes et ainsi des couches de contact desdits dispositifs microélectroniques différentes en rendant les couches de contact plus homogènes et uniformes en termes, par exemple, d'épaisseur, de composition, et de rugosité, etc.

ETAT DE LA TECHNIQUE

Les performances des dispositifs microélectroniques CMOS (acronyme de l'anglais « Complementary Metal Oxide Semiconductor ») sont étroitement liées à la réduction de la résistance des contacts électriques. L'amélioration du procédé de siliciuration auto-alignée est un des points clés pour atteindre les caractéristiques exigées pour le futur nœud technologique. Le procédé de siliciuration est en effet une réaction entre une couche métallique et une couche semi-conductrice permettant de limiter la résistance d'accès aux source et drain d'un transistor. Le matériau de la couche métallique peut être choisi parmi des métaux et des alliages tels qu'un alliage à base de nickel.

A l'heure actuelle, la couche métallique permettant la réaction de siliciuration est généralement réalisée par dépôt physique en phase vapeur (PVD, acronyme de l'anglais « physical vapor déposition ») sur la totalité de la surface supérieure continue de la plaquette de support des dispositifs à fabriquer. Ensuite, sous l'effet d'un traitement thermique, la couche métallique réagit préférentiellement avec des zones semi-conductrices plutôt qu'avec celles diélectriques. A cette étape, le recuit de formation d'une couche de siliciure est réalisé.

Un retrait sélectif est ensuite effectué préférentiellement par voie chimique pour retirer la portion de la couche métallique n'ayant pas réagi. Un nouveau traitement thermique est réalisé afin d'obtenir directement une couche d'un composé intermétallique ou d'une solution solide, ce qui est la phase la plus intéressante d'un point de vue métallurgique et électrique.

Les documents US 2005/156208 A1 et US 2006/121664 A1 divulguent de tels procédés qui présentent en outre l'avantage de d'obtenir des couches de contact de natures différentes entre elles pour les deux transistors N et P d'un même composant CMOS.

Pourtant, le procédé ci-dessus présente des inconvénients majeurs présentés ci-dessous :

(1) De nombreuses étapes sont nécessaires avant la réalisation de la siliciuration.
(2) Ce procédé implique une consommation élevée de métal, résultant de l'étape de dépôt de la couche métallique sur la surface entière de la plaquette et de l'étape de retrait sélectif pour retirer les parties de la couche métallique n'ayant pas réagi lors du premier traitement thermique. Une portion importante de la couche métallique est donc perdue.
(3) Le dépôt uniforme de la couche métallique en fond de tranchée à fort aspect ratio est difficile à réaliser par procédé PVD.
(4) Le dépôt réalisé par le procédé PVD crée un effet d'ombrage en fonction de la densité des motifs.
(5) Le dépôt par le procédé PVD réalisé de manière conventionnelle ne permet pas, sauf en cas de masquage, de déposer des métaux (ou alliages métalliques) différents sur les différentes zones de reprise de contact.

Afin de remédier en tout ou partie aux inconvénients ci-dessus, une autre solution propose un procédé de formation d'une couche métallique par la voie chimique et plus particulièrement par méthode autocatalytique sans apport de courant (de l'anglais « electroless déposition ») encore appelée voie électrochimique non assistée, au lieu du procédé PVD.

Ce procédé permet de déposer une couche métallique (ou une couche d'un matériau d'alliage) à faibles coûts sur la surface supérieure de la plaquette ou à l'intérieur de structures complexes. Par ailleurs, ce procédé permet, sous certaines conditions spécifiques, de déposer non pas une couche métallique mais deux couches métalliques différentes de façon sélective selon le substrat employé.

En fonction de différentes natures de substrats, il est aussi difficile d'obtenir une couche métallique identique sur des dispositifs intégrant des substrats différents tels que des substrats de matériaux semi-conducteurs différemment dopés par des types de dopants différents et/ou présentant des concentrations différentes, voire des matériaux semi-conducteurs différents. En effet, la morphologie (i.e. la rugosité, la taille de grain, la densité de grain) et/ou l'épaisseur critique (i.e. l'épaisseur à partir de laquelle la couche métallique est continue) seront différentes selon les matériaux employés, ce qui entraînera des difficultés d'intégration de ce procédé dans les dispositifs puisqu'une relation directe existe entre les caractéristiques des couches métalliques et la performance des contacts formés par la suite ; par exemple :

- une forte rugosité conduit à une augmentation de la résistance.
- l'épaisseur non-uniforme de la couche métallique conduit à une séquence de phases formées différentes ou des épaisseurs non uniformes sur l'ensemble de la plaquette et donc potentiellement à une variation non-désirée des résistances séries.
- l'impossibilité de former deux couches métalliques différentes :
  La flexibilité de choix des matériaux pour les couches métalliques et celle de conductivités désirées pour les couches de contacts obtenues sont limitées.

Il existe donc un besoin pour un procédé permettant d'optimiser le dépôt de deux couches métalliques identiques ou différentes pour un substrat donné, le procédé s'adaptant à des substrats comprenant des matériaux différents en surface.

RESUME DE L'INVENTION

La présente invention permet de remédier en tout ou partie aux inconvénients des techniques actuellement connues.

L'invention concerne un procédé de fabrication d'un dispositif microélectronique selon la revendication 1. Ce procédé comporte, sur la base d'un substrat, une formation d'une première couche d'un premier matériau semi-conducteur sur une première zone d'une surface supérieure du substrat ; une formation d'une deuxième couche d'un deuxième matériau semi-conducteur, sur une deuxième zone, distincte de la première zone, de la surface supérieure du substrat ; une formation d'une première couche métallique au-dessus de la première couche ; une formation d'une première couche de contact d'un premier composé intermétallique ou solution solide comprenant au moins une portion de la première couche et au moins une portion de la première couche métallique ; une formation d'une première couche sacrificielle par oxydation d'une portion supérieure de la première couche de contact, et d'une deuxième couche sacrificielle par oxydation d'une portion supérieure de la deuxième couche ; la réalisation d'un enlèvement de la totalité de la deuxième couche sacrificielle de sorte à exposer une portion résiduelle de la deuxième couche et d'un enlèvement partiel de la première couche sacrificielle ; une formation d'une deuxième couche métallique au-dessus de ladite portion résiduelle ; la formation d'une deuxième couche de contact d'un deuxième composé intermétallique ou solution solide comprenant au moins une portion de ladite portion résiduelle et au moins une portion de la deuxième couche métallique. L'épaisseur $e_1$ de la première couche sacrificielle est plus importante que l'épaisseur $e_2$ de la deuxième couche sacrificielle.

Un avantage potentiel de l'invention est de pallier au moins en partie des problèmes mentionnés ci-dessus en déposant deux couches métalliques identiques ou différentes et en uniformisant les couches de différents matériaux semi-conducteurs sur une même plaque ; par exemple, pour former deux transistors CMOS de type p et de type n, l'invention permettant un avantage avantageux de déposer deux couches métalliques différentes dont la différence entre la valeur de la bande de valence pour un semi-conducteur de type p et la valeur du travail de sortie du siliciure est inférieure à un demi-gap (ou « une demi bande interdite ») de ce même semi-conducteur ou dont la différence entre la valeur du travail de sortie du siliciure et la valeur de la bande de conduction pour un semi-conducteur de type n est inférieure à un demi-gap de ce même semi-conducteur.

BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

Les figures 1a et 1b résument des étapes de fabrication de dispositifs microélectroniques selon le procédé de l'invention.
Les figures 2a à 2i montrent les structures obtenues à l'issue des principales étapes de fabrication de transistors de deux types différents en réalisant deux couches métalliques identiques ou différentes sur une même plaque selon un premier mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

## DESCRIPTION DETAILLEE

L'invention s'adresse à la fabrication de tout dispositif tel que notamment, ceux indiqués précédemment. Ces fabrications impliquent des substrats ici définis comme des structures à au moins une couche de matériau, très avantageusement du type semi-conducteur, et formant un empilement ou encore une tranche de matériau(x) semi-conducteur(s). Le substrat peut former tout ou partie du dispositif microélectronique final ou être un élément intermédiaire au moins partiellement éliminé en cours de fabrication, par exemple en servant de support ou poignée pour la réalisation et/ou le transfert de couches fonctionnelles. On entend par surface supérieure du substrat une partie du substrat exposée vers l'extérieur et typiquement l'une des deux faces délimitant l'épaisseur du substrat.

La surface supérieure est avantageusement non plane du fait de la présence de parties de dispositifs ou encore de masques, par exemple. Une portion ou zone de la surface supérieure peut donc être en creux ou en protubérance relativement à d'autres portions ou zones de la surface supérieure.

Le terme « épaisseur » est employé pour définir une dimension dans le sens des empilements des couches du dispositif fabriqué. Le terme « largeur » est utilisé pour décrire une dimension orientée transversalement à l'épaisseur.

Les vocables du type « en-dessus, au-dessus, superposé, sous-jacente » ou équivalents, servent à décrire une position relative de deux parties du dispositif suivant la dimension en épaisseur de ce dernier. Ils n'impliquent pas systématiquement que les parties en question soient en contact et, par exemple, immédiatement au-dessus ou en-dessous.

Les expressions du type « égal, inférieur, supérieur » s'entendent de comparaisons entre des grandeurs, ces comparaisons pouvant accommoder certaines tolérances, notamment selon l'échelle de grandeur des valeurs comparées et les incertitudes de mesure. Des valeurs sensiblement égales, inférieures ou supérieures entrent dans le cadre d'interprétation de l'invention.

Avant d'entamer une revue détaillée de modes de réalisation de l'invention, sont énoncées ci-après des caractéristiques optionnelles qui peuvent éventuellement être utilisées selon les revendications dépendantes :

- la formation
  des première et deuxième couches sacrificielles comprend la réalisation d'un traitement thermique.
- le traitement thermique est réalisé lors d'une durée de 2 à 100 heures et à une température entre 700°C et 1200°C de sorte à former les première et deuxième couches sacrificielles.
- le procédé comprend, après la formation de la deuxième couche de contact, la réalisation d'un enlèvement total de la première couche sacrificielle.
- les première et deuxième couches sacrificielles sont enlevées par attaque chimique.
- les formations des première et deuxième couches de contact comprennent la réalisation d'un traitement thermique.
- le traitement thermique est réalisé lors d'une durée de 10 à 600 secondes et à une température entre 150°C et 500°C de sorte à former les première et deuxième couches de contact. Le traitement thermique est préférentiellement un recuit thermique rapide RTP (de l'anglais « rapid thermal process »), ou un recuit laser sous gaz neutre tel que l'argon (Ar), l'hélium (He), le hydrogène ($N_2$) ou à l'aide d'un réducteur tel que l'hydrogène gazeux ($H_2$). Ledit traitement thermique est réalisé à une pression comprise par exemple entre 1 et 2 atm (atmosphères).
- la première couche métallique et la deuxième couche métallique sont en des matériaux différents.
- le premier matériau semi-conducteur et le deuxième matériau semi-conducteur sont différents.
- la première couche métallique est formée préférentiellement par dépôt sélectif en dehors de zones comprenant des zones diélectriques de la surface supérieure du substrat et la deuxième couche du deuxième matériau semi-conducteur.
- la deuxième couche métallique est formée préférentiellement par dépôt sélectif en dehors de zones comprenant des zones diélectriques de la surface supérieure du substrat et celles de la première couche sacrificielle. Dans un autre mode de réalisation, ce dépôt de la deuxième couche métallique peut être réalisé de manière non sélective, par exemple par le dépôt PVD. Dans ce cas, la deuxième couche métallique se retrouve sur toute la surface supérieure de la plaque.
- au moins l'une parmi les première et deuxième couches métalliques est formée par voie électrochimique assistée.
- l'épaisseur de la première couche métallique et celle de la deuxième couche métallique sont supérieures à 5 nm.
  au moins l'un des premier et deuxième matériaux semi-conducteurs est choisi parmi des matériaux suivant : le silicium, une solution solide de silicium contenant du carbone, une solution solide de silicium ou de germanium, le germanium, le silicium-germanium, des matériaux III-V composés d'éléments des colonnes III et/ou V du tableau périodique standard des éléments.
- les premier et deuxième matériaux semi-conducteurs sont choisis parmi les matériaux suivant : le silicium, une solution solide de silicium contenant du carbone, une solution solide de silicium ou de germanium.
- les premier et deuxième matériaux semi-conducteurs sont choisis parmi des matériaux III-V composés d'éléments des colonnes III et/ou V du tableau périodique standard des éléments.

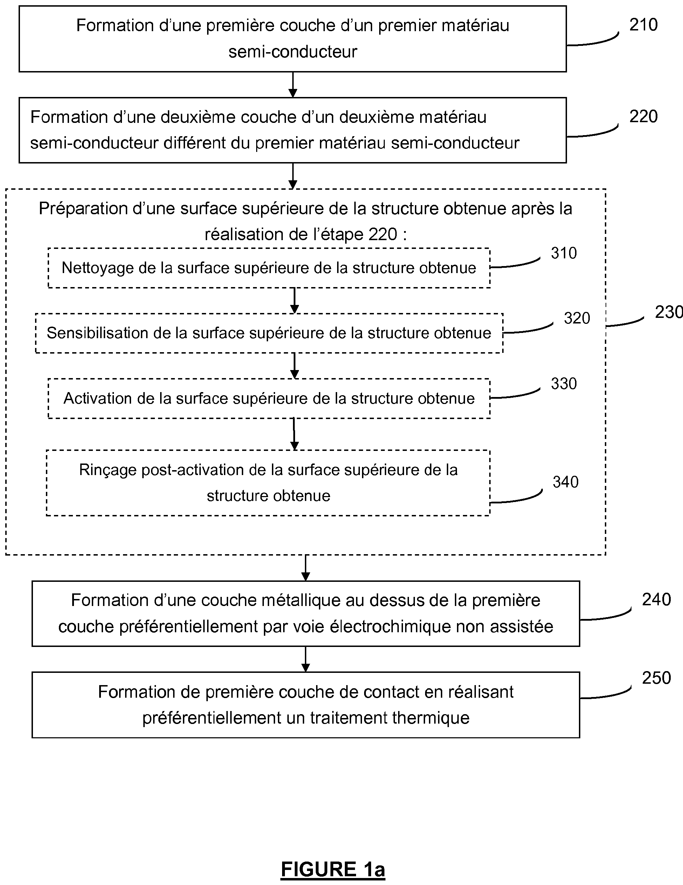

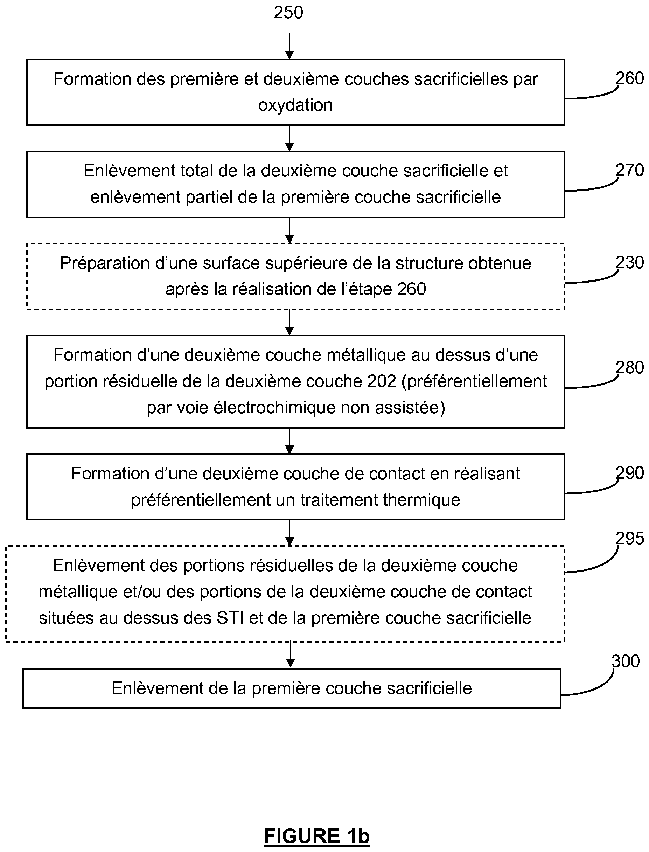

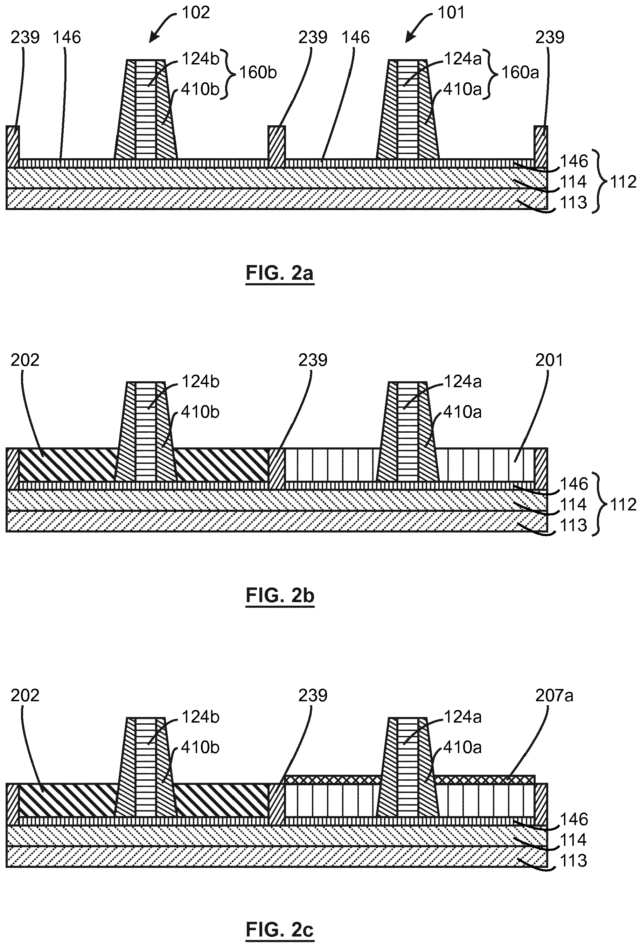

Les figures 1a et 1b résument des étapes 210 à 300 de fabrication de dispositifs microélectroniques selon le procédé de l'invention. Les figures 2a à 2i illustrent les principales étapes 210 à 300 de fabrication de transistors de deux types différents sur une même plaque encore dénommée substrat selon un premier mode de réalisation de l'invention. Deux transistors 101 et 102, respectivement de type NMOS et de type PMOS, seront illustrés dans les figures 2a à 2i afin de faciliter la compréhension. L'invention n'est pas limitée au nombre de transistors illustrés et certaines des couches mentionnées ci-dessous peuvent ne pas être présentes ou d'autres couches peuvent être rajoutées sans pour autant sortir du cadre de la présente invention.

La figure 2a montre la structure de départ d'un substrat 112 selon un premier mode de réalisation de l'invention.

Les circuits intégrés tels que les transistors 101, 102 peuvent être réalisés à partir d'un substrat de départ, très généralement fait de silicium massif et souvent qualifié du vocable anglais de « bulk » ou d'un substrat élaboré de type dit SOI, acronyme de l'anglais « silicon on insulator », c'est-à-dire « silicium sur isolant » et plus généralement « semi-conducteur sur isolant ».

Dans la figure 2a on retrouve le substrat 112 de type SOI comprenant un substrat initial 113 surmonté d'une couche isolante 114 et d'une couche superficielle 146. Le substrat initial 113 est le plus souvent une tranche homogène de silicium. La couche isolante 114 est préférentiellement une couche d'oxyde enterrée 114 qui assure l'isolation des composants qui seront fabriqués dans la fine couche superficielle 146 de semi-conducteur présente sur la couche enterrée 114. La couche superficielle 146 est constituée le plus souvent de silicium monocristallin. L'isolation des transistors 101, 102 est complétée par la réalisation de tranchées latérales d'isolation dites STI 239, acronyme de l'anglais « shallow trench isolation » c'est-à-dire « tranchées d'isolation peu profondes ». Elles atteignent la couche d'oxyde enterrée 114 pour englober chacun des transistors dans une couche continue d'oxyde 114. Ces tranchées, qui ne sont pas nécessaires à la compréhension de l'invention, ne sont pas représentées en détail.

Un empilement de grilles 160a, formé sur la couche superficielle 146, comprend au moins une grille 124a, un masque dur (non illustré en figures) recouvrant la surface supérieure de la grille 124a et des espaceurs 410a recouvrant les flancs de la grille 124a. Un empilement de grilles 160b, formé également sur la couche superficielle 146, comprend au moins une grille 124b, un masque dur (non illustré en figures) recouvrant la surface supérieure de la grille 124b et des espaceurs 410b recouvrant les flancs de la grille 124b. Lesdits masques durs sont configurés pour protéger les grilles 124a, 124b lors de la formation des sources et drains tels que des couches 201, 202 (illustrées ultérieurement) par épitaxie ou l'implantation des jonctions n et p. Lesdits masques durs sont également utilisés lors de la réalisation de l'étape 230 (illustrée ultérieurement) de formation d'un revêtement intermédiaire 205.

Le matériau de la grille 124a peut être différent de celui de la grille 124b. Le matériau des espaceurs 410a peut également être différent de celui des espaceurs 410b. Ces empilements de grilles 160a, 160b, qui ne sont pas nécessaires à la compréhension de l'invention, ne sont pas représentés en détail.

L'invention n'est pas limitée aux exemples précédents de réalisation de la préparation du substrat 112, des STI 239, des formations des empilements de grille 160a, 160b et de la préparation de la surface supérieure de la couche superficielle 146 du substrat 112.

La figure 2b montre la structure obtenue à l'issue de l'étape 210 de formation d'une première couche 201 d'un premier matériau semi-conducteur et d'une deuxième couche 202 d'un deuxième matériau semi-conducteur, respectivement sur une première zone pour le transistor 101 et une deuxième zone pour le transistor 102.

De manière préférentielle mais non limitative, l'étape 210 consiste d'abord à déposer un masque (non illustré en figure 2b) et former ensuite la première couche 201 sur la première zone de la surface supérieure du substrat 112 en dehors de l'empilement de grilles 160a. On notera que le terme « zone » peut s'appliquer à toute partie de surface de toutes formes et dimensions adaptées à l'application. Elle peut être en une ou plusieurs portions espacées.

Avant de former la première couche 201, un masque est préférentiellement déposé en dehors de la première zone de la surface supérieure du substrat 112 pour que la première couche 201 soit formée uniquement en première zone de la surface supérieure du substrat 112. Plus précisément, le masque est préférentiellement déposé sur une deuxième zone de la surface supérieure du substrat 112 pour couvrir entièrement et protéger ainsi l'empilement de grilles 160b et la deuxième zone de la surface supérieure de la couche superficielle 146. Le matériau du masque est par exemple de $SiO_2$.

La formation de la première couche 201 est ensuite effectuée sur la première zone par un procédé tel que l'épitaxie sélective du premier matériau semi-conducteur. Cette première couche 201 est destinée à participer à la formation d'une première couche de contact 281 (décrite ultérieurement). Ce premier matériau semi-conducteur est avantageusement différent d'un deuxième matériau semi-conducteur utilisé pour former ultérieurement une autre couche de contact 282 (décrite ultérieurement).

A titre d'exemple, pour les intégrations CMOS couramment rencontrées, la première couche 201 est composée soit de silicium (Si) de type n ou soit d'une solution solide contenant du carbone (C), une deuxième couche 202 étant composée du Si de type p ou de SiGe.

De plus, dans un autre exemple, la première couche 201 est composée du Si de type p ou de SiGe, la deuxième couche 202 étant composée du Si de type n ou une solution de Si contenant du carbone.

Il faut en outre noter que l'invention n'est pas limitée à l'ordre de la réalisation des couches 201 et 202 ni aux exemples ci-dessus. Les premier et deuxième matériaux semi-conducteurs peuvent être identiques ou différents selon les méthodes de réalisation des couches 201 et 202 ou/et les fonctions des transistors 101 et 102.

Selon ce mode de réalisation, de manière préférentielle mais non limitative, au moins l'un parmi les premier et deuxième matériaux semi-conducteurs est choisi parmi des matériaux suivants : le silicium, une solution solide de silicium contenant du carbone, le germanium, le silicium-germanium, des matériaux composés d'éléments des colonnes III et/ou V de la classification périodique des éléments des éléments, selon les besoins.

Ainsi, la première couche 201 est formée de part et d'autre de l'empilement de grilles 160a sur la première zone du substrat 112. De manière préférentielle mais non limitative, l'épaisseur de la première couche 201 est de 5 à 20 nm (nanomètres).

Le masque est ensuite retiré après la formation de la première couche 201.

Préférentiellement, la deuxième couche 202 peut être réalisée de la même manière que la première couche 201 est formée. L'étape 210 consiste donc à déposer ensuite un masque (non illustré en figure 2b) et former la deuxième couche 202 sur la deuxième zone de la surface supérieure du substrat 112 en dehors de l'empilement de grilles 160b.

Avant de former la deuxième couche 202, un masque est préférentiellement déposé en dehors de la deuxième zone de la surface supérieure du substrat 112 pour que la deuxième couche 202 soit formée uniquement en deuxième zone de la surface supérieure du substrat 112. Plus précisément, le masque est préférentiellement déposé sur une première zone de la surface supérieure du substrat 112 pour couvrir entièrement et protéger ainsi l'empilement de grilles 160a et la première zone de la surface supérieure de la couche superficielle 146. Le matériau du masque est par exemple du SiO$_2$.

La formation de la deuxième couche 202 est ensuite effectuée de manière telle que l'épitaxie sélective du deuxième matériau semi-conducteur. Pour rappel, le deuxième matériau semi-conducteur est avantageusement différent que le premier matériau semi-conducteur.

Ainsi, la deuxième couche 202 est formée de part et d'autre de l'empilement de grilles 160b sur la deuxième zone du substrat 112. De manière préférentielle mais non limitative, l'épaisseur de la deuxième couche 202 est de 5 à 20 nm.

Le masque est retiré après la formation de la deuxième couche 202.

L'invention n'est pas limitée à la réalisation des masques ni aux exemples de réalisation des première et deuxième couches 201 et 202.

La figure 2c montre la structure obtenue à l'issue de l'étape 240 de formation d'une couche métallique 207a pour le transistor 101.

Afin de faciliter la réalisation de l'étape 240, une étape 230 de préparation des surfaces supérieures des première et deuxième couches 201 et/ou 202 est réalisée avant l'étape 240.

Cette étape 230 est optionnelle selon la nature du premier matériau et les types de dispositifs à réaliser. Un exemple de la réalisation de l'étape 230 composée de quatre étapes 310 à 340 sera illustré ci-dessous. L'invention n'est pas limitée aux modes de réalisation de l'étape optionnelle 230 ; c'est-à-dire l'étape 230 ne comprend pas nécessairement toutes les quatre étapes 310 à 340 et pourrait être réalisée autrement.

L'étape 310 consiste à nettoyer la surface supérieure de la structure obtenue après la réalisation de l'étape 220 comprenant les surfaces supérieures des première et deuxième couches 201 et/ou 202. Une solution de nettoyage par exemple d'acide fluorhydrique est utilisée à cette étape.

L'étape 320 de sensibilisation des surfaces supérieures des première et deuxième couches 201 et/ou 202 est réalisée en utilisant une solution de sensibilisation par exemple une solution acide de sel d'étain. Cette solution de sensibilisation peut également contenir un additif modifiant les propriétés d'adsorption des ions étain.

Un exemple de formation de la composition de la solution de sensibilisation est décrit dans le tableau ci-dessous :

| Solution aqueuse | SnCl$_2$ (chlorure d'étain(II)), 2H$_2$O | HCl (chlorure d'hydrogène) | H$_2$O |
|---|---|---|---|
| | 2,26 g (gramme) | 0.8 ml (millilitre) | 100 ml |

L'étape 330 d'activation des surfaces supérieures de la première couche 201 et/ou de la deuxième couche 202 est ensuite réalisée en utilisant une solution d'activation par exemple de palladium. La composition de la solution d'activation peut être variée et adaptée selon la nature d'un premier matériau semi-conducteur à employer.

La sélectivité d'un dépôt d'une couche métallique formée ultérieurement (par exemple la couche métallique 207a formée à l'étape suivante 240 ou la deuxième couche métallique 207b formée à l'étape 280) peut être ajustée via un bain d'activation utilisé à ce stade, soit par modification de la composition du bain, soit par modification des concentrations des réactifs.

Voici des exemples de solutions d'activation utilisables pour préparer les surfaces supérieures des première et deuxième couches 201 et/ou 202 pour un dépôt de nickel. Trois exemples de formation de la composition de la solution d'activation sont décrits dans les trois tableaux ci-dessous pour expliquer dans quels cas les solutions d'activation sont utilisées suivant leurs propriétés d'activation sur divers matériaux :

Premier exemple : l'application de la solution d'activation sur le silicium de type n:

| | $Si_xN_y$ | $SiO_x$ | SiGe | Si n (As) | Si n (P) | Si p | Si p+ |
|---|---|---|---|---|---|---|---|
| PdCl$_2$ (palladium(II) chloride) + AcOH (acide acétique) | Non | Non | Non | Oui | Oui | Non | Non |

Deuxième exemple : l'application de la solution d'activation sur le silicium de type n ou p :

| | $Si_xN_y$ | $SiO_x$ | SiGe | Si n (As) | Si n (P) | Si p | Si p+ |
|---|---|---|---|---|---|---|---|
| PdCl$_2$ + HF + AcOH | Non | Non | Non | Oui | Oui | Oui | Oui |

Troisième exemple : l'application de la solution d'activation sur le silicium de type n ou p, le SiGe, l'oxyde de silicium ($SiO_x$), le nitrure de silicium ($Si_XN_Y$) :

| | $Si_xN_y$ | $SiO_x$ | SiGe | Si n (As) | Si n (P) | Si p | Si p+ |
|---|---|---|---|---|---|---|---|
| PdCl$_2$ | Oui | Oui | Oui | Oui | Oui | Oui | Oui |

La solution d'activation est avantageusement configurée pour activer les zones de la surface supérieure de l'une parmi les première et deuxième couches 201 et 202 sur lesquelles deux couches métalliques 207a, 207b sont à former, et, préférentiellement pour ne pas activer des zones telles que les parties diélectriques et la surface supérieure de l'autre des couches 201, 202. Cela permet de rendre sélective la formation des première et deuxième couches métalliques 207a, 207b. Ensuite, l'étape 340 de rinçage post-activation des surfaces supérieures des première et/ou deuxième couches 201 et/ou 202 est effectuée. Cette étape 340 peut être réalisée de différentes manières telles qu'un rinçage EDI (abrégé de « Electrodesionisation ») uniquement, un rinçage EDI sous ultrasons, ou un rinçage réalisé dans des bains successifs de EDI / HF / EDI. Cette étape 340 permet d'optimiser la réalisation de l'étape suivante 240 comportant par exemple un dépôt du nickel (Ni) par voie électrochimique non assistée et ce en fonction de l'intégration et du substrat.

Ensuite, l'étape 240 de formation d'une première couche métallique 207a pour le transistor 101 est effectuée. Cette étape 240 consiste à former la première couche métallique 207a au-dessus de la première couche 201, de manière préférentielle mais non limitative, par voie électrochimique non assistée (de l'anglais « electroless déposition »). Une solution utilisée dans un bain contenant par exemple un sel de métal, un agent réducteur, un agent complexant et un stabilisateur est employée afin d'effectuer une réaction chimique pour former ensuite la première couche métallique 207a. Par exemple, la première couche métallique 207a de matériau à base de nickel (Ni) est obtenue à l'issue de la réalisation d'un bain de nickel par voie électrochimique non assistée en utilisant une solution telle qu'une solution commerciale comportant un sel de métal, un agent réducteur, un agent complexant et un stabilisateur.

De plus, en fonction de la nature de la première couche 201 de type n, on utilisera avantageusement un dépôt d'alliage de nickel à base de terres rares en proportions pondérales préférentiellement entre 0-20 %.

Les conditions de réalisation d'un bain, telles que la température et le pH, dépendent des facteurs de la solution commerciale ou la solution formulée tels que la composition du bain, les concentrations des différents constituants du bain, etc. Prenons l'exemple ci-dessus, la réaction chimique est effectuée entre 60 et 80°C selon les substrats 112 employés et préférentiellement entre 70 et 75°C.

Le matériau de la première couche métallique 207a peut être un métal ou un alliage, selon la solution à appliquer choisie.

L'épaisseur de la première couche métallique 207a est déterminée en fonction de celle de la première couche 201. Plus précisément, l'épaisseur de la première couche métallique 207a devrait être inférieure à celle de la première couche 201.

L'épaisseur de la première couche métallique 207a est préférentiellement supérieure à une épaisseur seuil (i.e. entre 1 à 20 nm).

Afin de déterminer ladite épaisseur seuil de la première couche métallique 207a, une possibilité est de calculer le volume $V_{at}^i$ d'un atome du matériau pour chacune couche i telle qu'une portion supérieure (RI) de la première couche 201 destinée à faire réagir avec la première couche métallique 207a, la première couche métallique (CM) 207a, et la première couche de contact (CC) 281 (formée ultérieurement à l'étape 250). Les valeurs $V_{at}^i$ pour les trois couches ci-dessus sont donc respectivement représentées comme $V_{at}^{RI}$, $V_{at}^{CM}$, $V_{at}^{CC}$.

Un exemple de calcul sur la valeur $V_{at}^i$ est présenté dans les formules ci-dessous :

$$V_{at}^i = V_{Ma}^i / N_{at}^i$$

Où $V_{Ma}^i$ représente le volume de la maille cristalline du matériau de la couche i, et $N_{at}^i$ représente le nombre d'atome par maille du matériau de la couche i.

Deux exemples de calcul de la valeur $V_{Ma}^i$ :

- Phase cubique : $V_{Ma}^i = a^3$
- Phase orthorhombique : $V_{Ma}^i = a*b*c$

Où a, b et c représentent les paramètres de maille.

Ainsi, les valeurs $V_{at}^{RI}$, $V_{at}^{CM}$, $V_{at}^{CC}$ peuvent être obtenues et, par conséquent, ladite épaisseur seuil de la première couche métallique 207a pourra être obtenue en calculant le ratio de volume tel que $V_{at}^{CM} / V_{at}^{RI}$ présenté dans le tableau ci-dessous :

| RI ( portion supérieure (RI) de la première couche 201) | + | CM (première couche métallique 207a) | → | CC (première couche de contact 281) |
|---|---|---|---|---|
| $V_{at}^{RI}$ | | $V_{at}^{CM}$ | | $V_{at}^{CC}$ |
| 1 | | $V_{at}^{CM}/V_{at}^{RI}$ | | $V_{at}^{CC}/V_{at}^{RI}$ |

Le tableau ci-dessous présente deux exemples chiffrés avec le premier matériau semi-conducteur du revêtement intermédiaire 205 est le silicium :

| | RI ( portion supérieure (RI) de la première couche 201) | + | CM (première métallique 207a) | → | CC (première couche de contact) |
|---|---|---|---|---|---|
| Matériau | 2 Si | | Ni | | $NiSi_2$ |
| Ratio de volume | 1 | | $V_{at}^{CM} / (2 \times V_{at}^{RI}) = 0.27$ | | $V_{at}^{CC} / (2 \times V_{at}^{RI}) = 1.97$ |
| Matériau | Si | | Ni | | $NiSi_2$ |
| Ratio de volume | 1 | | $V_{at}^{CM} / V_{at}^{RI}) = 0.55$ | | $V_{at}^{CC} / (2 \times V_{at}^{RI}) = 1.2$ |

Où :

$V_{at}^{Ni} = (3.535.10^{-10})^3 / 4 = 1.10435.10^{-29}$
$V_{at}^{Si} = (5.4309.10^{-10})^3 / 8 = 2.00228.10^{-29}$
$V_{at}^{NiSi2} = (5.406.10^{-10}) / 4 = 3.94974.10^{-29}$
$V_{at}^{NiSi} = (5.23*3.258*7.04.10^{-10}) / 4 = 2.41202.10^{-29}$

Le tableau ci-dessous présente plus d'exemples chiffrés si le premier matériau semi-conducteur de la première couche 201 est le silicium :

| RI (portion supérieure (RI) de la première couche 201) | CM (première couche métallique 207a) | CC (première couche de contact 281) / siliciure formé |
|---|---|---|
| Si<br>1 | Ni<br>0.55 | NiSi<br>1.2 |
| 2 Si<br>1 | Ni<br>0.27 | $NiSi_2$<br>1.97 |
| Si<br>1 | 2 Pd<br>1.47 | $Pd_2Si$<br>1.76 |
| Si<br>1 | Pt<br>0.74 | PtSi<br>1.47 |
| Si<br>1 | 2 Co<br>1.1 | $Co_2Si$<br>1.61 |
| 2Si<br>2.24 | Ti<br>0.45 | $TiSi_2$<br>1.11 |

Le tableau ci-dessous présente des exemples chiffrés si le premier matériau semi-conducteur de la première couche 201 est le germanium :

| RI (portion supérieure (RI) de la première couche 201) | CM (première couche métallique 207a) | CC (première couche de contact 281) / Germaniure formé |
|---|---|---|
| Ge | Ni | NiGe |
| 1 | 0.46 | 0.41 |
| Ge | 2 Ni | $Ni_2Ge$ |
| 1 | 0.97 | 0.62 |
| Ge | Pd | PdGe |
| 1 | 0.65 | 0.43 |
| Ge | Pt | PtGe |
| 1 | 0.67 | 0.45 |

Pour faciliter la compréhension, trois exemples d'une séquence de réalisation des étapes 230 (comportant des étapes 310 à 340) et 240 sont brièvement décrits ci-dessous. Plusieurs fluides, comme indiquées dans les trois tableaux ci-dessous, sont avantageusement appliqués successivement aux surfaces supérieures des première et deuxième couches 201 et/ou 202.

Les paramètres utilisables respectivement correspondants à chaque fluide sont également indiqués dans les tableaux de phases successives ci-dessous. L'application des fluides se commence par l'acide et se termine par de l'eau désionisée (EDI) ou par de l'eau $H_2O$.

Le premier exemple d'une séquence de réalisation des étapes 230 (comportant des étapes 310 à 340) et 240 :

| Solution aqueuse | HF 1% (acide fluorhydrique) | $Sn^{2+}$ | $H_2O$ | $Pd^{2+}$ | $H_2O$ | $Ni^{2+}$ | EDI |
|---|---|---|---|---|---|---|---|
| Durée (secondes) | 10 | 600 | 10 | 120 | 10 | 30 | 10 |
| Température (°C) | Température ambiante (TA) | TA | TA | TA | TA | 75 | TA |

Le deuxième exemple :

| Solution aqueuse | HF 1% | Sn$^{2+}$ | H$_2$O | Pd$^{2+}$ | H$_2$O | HF0.1% | H$_2$O | Ni$^{2+}$ | H$_2$O |
|---|---|---|---|---|---|---|---|---|---|
| Durée (secondes) | 10 | 600 | 10 | 30 | 10 | 10 | 10 | 20 | 10 |
| Température (°C) | Température ambiante (TA) | TA | TA | TA | TA | TA | TA | 75 | TA |

Le troisième exemple :

| Solution aqueuse | HF 1% | Sn$^{2+}$ | H$_2$O | Pd$^{2+}$ | H$_2$O/US | Ni$^{2+}$ | H$_2$O |
|---|---|---|---|---|---|---|---|
| Durée (secondes) | 10 | 600 | 10 | 120 | 120 | 30 | 10 |
| Température (°C) | Température ambiante (TA) | TA | TA | TA | TA | 75 | TA |

A l'issue de cette étape 340, plusieurs fonctions, telles que l'élimination des résidus de solution utilisée (i.e. le premier exemple), l'élimination du palladium (i.e. le deuxième exemple) sur l'oxyde de silicium (SiO$_X$) ou le nitrure de silicium (Si$_X$N$_Y$) pour obtenir un dépôt de nickel uniquement sur les substrats semi-conducteurs (Si, SiGe), et l'amélioration de la qualité telle que l'épaisseur et la rugosité plus faibles de la première couche métallique 207a formée ultérieurement (par dépôt du nickel par exemple), sont obtenues selon des modes de réalisations différents.

Ainsi, la première couche métallique 207a est donc formée par dépôt sélectif en dehors de zones comprenant des zones diélectriques de la surface supérieure du substrat 112 et la deuxième couche 202 du deuxième matériau semi-conducteur; plus précisément, la première couche métallique 207a est positionnée au-dessus de la première couche 201 du premier matériau semi-conducteur et formée autour de l'empilement de grilles 160a et non pas sur la deuxième couche 202 et des éléments diélectriques tels que les STI 239, les espaceurs 410a, 410b et les masques durs recouvrant les grilles 124a, 124b. Par exemple, la sélectivité dépend de la solution de Pd utilisée et/ou du rinçage associé tel que les trois rinçages mentionnés ci-dessus dans la description concernant l'étape 340.

Selon l'invention, les empilements de grilles 160a, 160b ne sont préférentiellement pas couverts par la première couche métallique 207a, ce qui permet de réduire la quantité du matériau de la couche métallique perdue par rapport à un procédé connu.

Pour rappel, selon un procédé connu de dépôt PVD, les empilements de grille sont totalement couverts par une couche métallique. Pourtant, lors d'une étape suivante de recuit (décrite ultérieurement), les parties de la couche métallique recouvrant les empilements de grilles ne réagiront pas avec des zones diélectriques telles que les espaceurs 410a, 410b et les masques durs (non illustrés en figures) recouvrant respectivement les surfaces supérieures des grilles 124a, 124b ; c'est-à-dire lesdites parties de la couche métallique sont non désirées et seront perdues, ce qui entraînera une consommation inutile du matériau des couches métalliques au cours de l'étape de recuit.

De plus, la séquence de fabrication des dispositifs est simplifiée car le procédé de l'invention ne nécessite plus systématiquement de retirer lesdites parties de la couche métallique n'ayant pas réagi.

L'invention n'est pas limitée aux matériaux ni à la méthode de réalisation de la première couche métallique 207a.

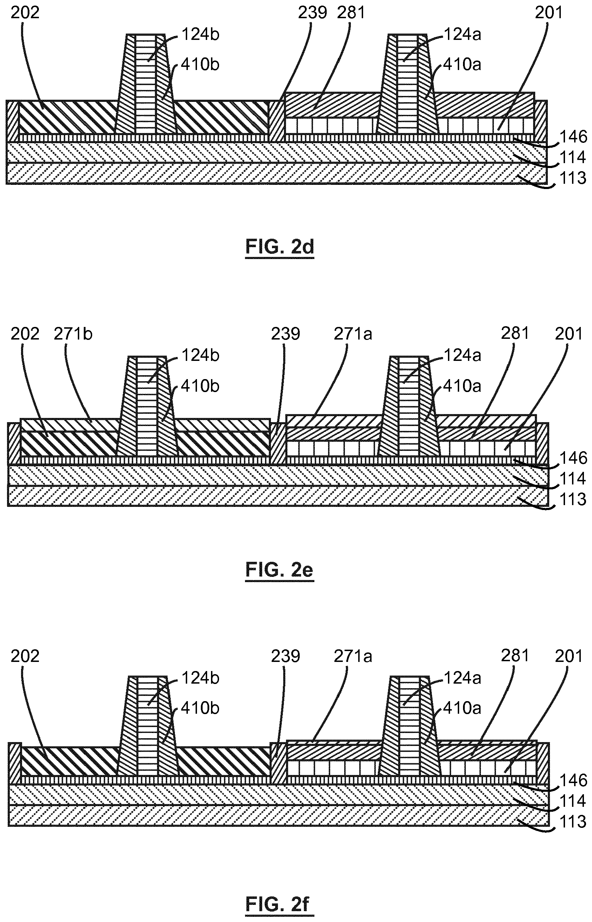

La figure 2d montre la structure obtenue à l'issue de l'étape 250 de formation d'une première couche de contact 281 pour le transistor 101. Cette couche de contact 281 forme de façon générale des portions de dispositifs, servant avantageusement à la conduction électrique, issues du procédé de l'invention.

L'étape 250 consiste à réaliser préférentiellement un traitement thermique de sorte à former la première couche de contact 281 d'un premier composé intermétallique ou solution solide, composée des deux matériaux suivants : le matériau de la première couche métallique 207a et du premier matériau semi-conducteur d'au moins une portion supérieure de la première couche 201.

Les paramètres de ce recuit sont déterminés selon le premier matériau semi-conducteur et/ou le matériau de la première couche métallique 207a employé. Le premier composé intermétallique ou solution solide obtenu peut être soit un composé intermétallique (entre un métal et un matériau semi-conducteur) soit un alliage métal/semi-conducteur. Il peut typiquement s'agir d'une siliciuration lorsque le premier matériau semi-conducteur est ou comprend du silicium.

Prenant un exemple préférentiel où le premier matériau semi-conducteur est choisi parmi le silicium, le silicium-germanium (SiGe) ou le silicium carbone (SiC), le traitement thermique est effectué par exemple à une température 150°C à 500°C pendant 10 à 120 secondes pour provoquer une réaction de siliciuration et obtenir ainsi le premier composé intermétallique ou solution solide.

L'invention n'est pas limitée à la méthode de réalisation de la première couche de contact 281.

La figure 2e montre la structure obtenue à l'issue de l'étape 260 de formation des première et deuxième couches sacrificielles 271a, 271b par oxydation. Cette étape 260 consiste à réaliser préférentiellement un traitement thermique afin d'oxyder respectivement une portion supérieure de la première couche de contact 281 et une portion supérieure de la deuxième couche 202, de sorte à former respectivement la première couche sacrificielle 271a d'une épaisseur $e_1$ et la deuxième couche sacrificielle 271b d'une épaisseur $e_2$.

Les paramètres de ce recuit sont déterminés selon plusieurs facteurs, tels que la vitesse d'oxydation de la première couche de contact 281 et celle de la deuxième couche 202, le matériau obtenu de la première couche de contact 281 et/ou le deuxième matériau semi-conducteur de la deuxième couche 202, etc. La vitesse d'oxydation de la première couche de contact 281 doit être plus rapide que celle de la deuxième couche 202, afin de former l'épaisseur $e_1$ qui est supérieure à l'épaisseur $e_2$.

De manière préférentielle mais non limitative, l'épaisseur $e_2$ de la deuxième couche sacrificielle 271b peut être très fine par rapport à l'épaisseur $e_1$ de la première couche sacrificielle 271a, qui est par exemple au moins le double de $e_2$

Les épaisseurs $e_1$ et $e_2$ obtenues à l'issue du traitement thermique sont fonction de la durée du traitement thermique et/ou à la température appliquée et/ou à la pression appliquée. Deux exemples sont décrits ci-dessous.

Prenant un exemple préférentiel, la première couche de contact 281 est en $NiSi_2$ et la deuxième couche 202 est en silicium. L'oxydation du siliciure (i.e. $NiSi_2$) est plus rapide que celle du silicium réalisée à la même température et dans une même durée du traitement thermique.

Le traitement thermique est effectué par exemple à une température entre 800°C et 1200°C et de préférence entre 700°C et 900°C. Dans un exemple, le traitement thermique est effectué à 700°C pendant 20 heures de sorte à former les première et deuxième couches sacrificielles 271a et 271b respectivement présentant une épaisseur de 50 nm et celle de 17 nm.

Dans un autre exemple, la première couche de contact 281 est en $CoSi_2$ et la deuxième couche 202 est en silicium. La vitesse d'oxydation du $CoSi_2$ est environ deux fois que celle du Si sous la même pression.

Un traitement thermique est effectué par exemple sous 1 Torr pendant une heure de sorte à former les première et deuxième couches sacrificielles 271a et 271b respectivement présentant une épaisseur de 36 nm et de 18 nm.

De plus, en raison de la réalisation de ce recuit, l'épaisseur d'une portion résiduelle de la deuxième couche 202 est effectivement moins importante que l'épaisseur de la deuxième couche 202 obtenue à l'issue de l'étape 220.

L'étape 270 consistant à enlever totalement la deuxième couche sacrificielle 271b et partiellement la première couche sacrificielle 271a est ensuite réalisée de sorte à exposer la portion résiduelle de la deuxième couche 202. A l'issue de l'étape 270, une surface supérieure de la portion résiduelle de la deuxième couche 202 est ainsi mise à nu en gardant sur place une épaisseur résiduelle de la première couche sacrificielle 271a, comme illustré en figure 2f. La surface supérieure de ladite portion résiduelle est donc prête pour la réalisation de l'étape 280 suivante (décrite ultérieurement) de formation d'une deuxième couche métallique 207b.

De manière préférentielle mais non limitative, les deux couches sacrificielles 271a et 271b sont enlevées par attaque chimique telle que la gravure diluée à l'acide fluorhydrique (HF) ou la gravure au plasma détourné ($NF_3$, $NH_3$).

De plus, il est important de choisir soigneusement les matériaux des couches formées et les méthodes réalisées dans les étapes précédentes 220 à 260 et la méthode d'enlèvement effectuée à l'étape 270 afin de s'assurer d'obtenir le résultat désiré de l'étape 270, c'est-à-dire la préservation d'une partie de portion résiduelle de la première couche sacrificielle 271a. En outre, pour cette fin, l'épaisseur $e_1$ de la première couche sacrificielle 271a obtenue à l'issue de l'étape 260 est plus importante que l'épaisseur $e_2$ de la deuxième couche sacrificielle 271b obtenue. Dans ce cas, si l'attaque chimique des deux couches sacrificielles 271a et 271b a la même cinétique, cette différence d'épaisseur assure un enlèvement partiel pour l'épaisseur $e_1$ et total pour l'épaisseur $e_2$.

L'invention n'est pas limitée à la méthode d'enlèvement ci-dessus des première et deuxième couches sacrificielles 271a et 271b.

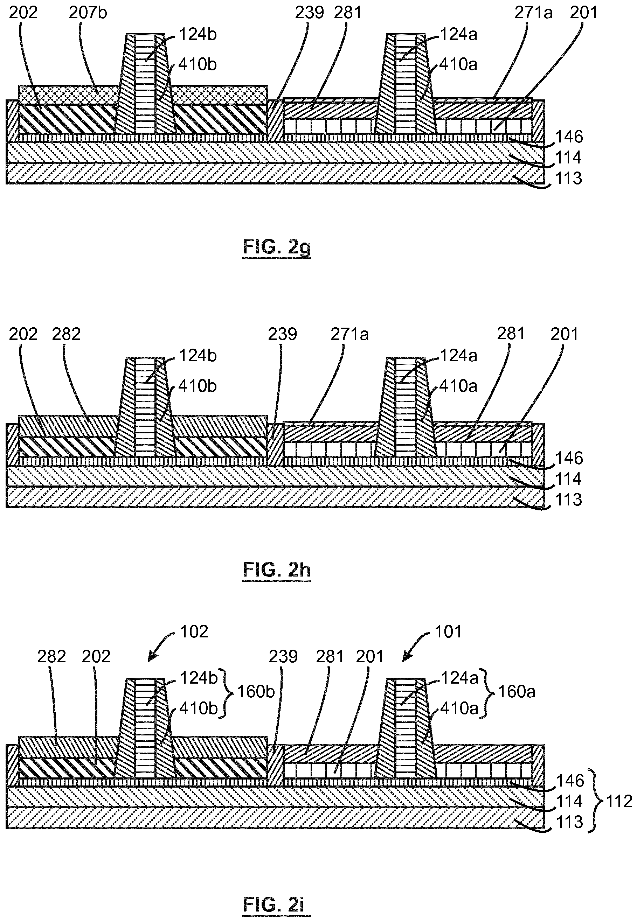

La figure 2g montre la structure obtenue à l'issue de l'étape 280 de formation d'une deuxième couche métallique 207b pour le transistor 102. Cette étape 280 consiste à former la deuxième couche métallique 207b au-dessus de ladite portion résiduelle de la deuxième couche 202, de manière préférentielle mais non limitative, par voie électrochimique non assistée (de l'anglais « electroless déposition »). Plus précisément, il reste effectivement à ce stade une seule zone semi-conductrice exposée sur la plaque, à savoir la deuxième couche 202. L'étape 280 de formation de la deuxième couche métallique 207b peut donc être considérée comme réalisée de manière « auto-sélective ».

Dans un autre mode de réalisation, la deuxième couche métallique 207b est réalisée de manière non sélective, par exemple par PVD, sur la totalité de la surface supérieure continue de la plaquette. Comme décrit ultérieurement, il y a ensuite une étape d'enlèvement partiel de ce dépôt.

Selon le présent mode de réalisation, la deuxième couche métallique 207b est formée par dépôt sélectif en dehors de zones comprenant des zones diélectriques de la surface supérieure du substrat 112 et celles de la première couche sacrificielle 271a ; plus précisément, la deuxième couche métallique 207b est positionnée au-dessus de la deuxième couche 202 du deuxième matériau semi-conducteur et formée autour de l'empilement de grilles 160b au lieu de sur des éléments diélectriques tels que les STI 239, les espaceurs 410a, 410b, les masques durs recouvrant les grilles 124a, 124b et la première couche sacrificielle 271a.

L'épaisseur de la deuxième couche métallique 207b est déterminée en fonction de celle de la deuxième couche 202. Plus précisément, l'épaisseur de la deuxième couche métallique 207b devrait être suffisamment inférieure à celle de la deuxième couche 202.

L'épaisseur de la deuxième couche métallique 207b est de préférence supérieure à une épaisseur seuil (i.e. entre 1 à 20 nm).

Afin de déterminer ladite épaisseur seuil de la deuxième couche métallique 207b, une possibilité est de calculer le volume $V_{at}^i$ d'un atome du matériau pour chacune couche i telle qu'une portion supérieure (RI) de la deuxième couche 202, la deuxième couche métallique (CM) 207b, la deuxième couche de contact (CC) 282 (formées ultérieurement à l'étape 290). Les valeurs $V_{at}^i$ pour les trois couches ci-dessus sont donc respectivement représentées comme $V_{at}^{RI}$, $V_{at}^{CM}$, $V_{at}^{CC}$.

La description détaillée de l'épaisseur seuil de la deuxième couche métallique 207b est similaire à celui de l'épaisseur seuil de la première couche métallique 207a comme précédemment décrit et on pourra donc ici adapter à un calcul équivalent.

Les caractéristiques indiquées en description des étapes 230 et 240 notamment à propos de l'épaisseur, des choix de matériau et de la méthode de formation de la première couche métallique 207a sont valables pour la réalisation de la deuxième couche métallique 207b.

En fonction de la nature de la deuxième couche 202 de type p, on ajustera le travail de sortie du siliciure en ajoutant avantageusement à la deuxième couche métallique 207b du palladium ou du platine pour la deuxième couche 202 de type p dans une gamme de concentration 0-20 %.

Il faut noter que la première couche métallique 207a et la deuxième couche métallique 207b peuvent être en des matériaux différents ou identiques, ce qui dépend des caractéristiques (telles que la conductivité) des transistors 101, 102 désirées.

La figure 2h montre la structure obtenue à l'issue de l'étape 290 de formation d'une deuxième couche de contact 282 pour le transistor 102. Cette couche de contact 282 forme de façon générale des portions de dispositifs, servant avantageusement à la conduction électrique.

L'étape 290 consiste à réaliser préférentiellement un traitement thermique de sorte à former la deuxième couche de contact 282 d'un deuxième composé intermétallique ou solution solide composé des deux matériaux suivants : le matériau de la deuxième couche métallique 207b et le deuxième matériau semi-conducteur d'une portion supérieure de ladite portion résiduelle de la deuxième couche 202.

La description des paramètres du recuit effectué à l'étape 250 est valable pour la réalisation d'un recuit effectué à cette étape 290 de sorte à former la deuxième couche de contact 282.

L'étape 295 est une étape facultative réalisée dans un mode de réalisation où la deuxième couche métallique 207b est formée à l'étape 280 de manière non sélective. Cette étape 295 consiste à enlever des portions résiduelles de la deuxième couche métallique 207b et/ou des portions de la deuxième couche de contact 282 qui sont situées en dehors de la deuxième zone ; c'est-à-dire à enlever les portions de la deuxième couche de contact 282 situées au-dessus des STI 239 et de la première couche sacrificielle 271a.

L'invention n'est pas limitée à la méthode ci-dessus d'enlèvement des portions de la deuxième couche de contact 282 et des portions résiduelles de la deuxième couche métallique 207b.

L'étape 300 consistant à enlever totalement la première couche sacrificielle 271a est ensuite réalisée de sorte à exposer la première couche de contact 281, comme illustré en figure 2i.

De manière préférentielle mais non limitative, la première couche sacrificielle 271a est enlevée par attaque chimique telle que la gravure diluée à l'acide fluorhydrique (HF) ou par gravure au plasma détourné (NF$_3$, NH$_3$).

Il faut noter que ce procédé de l'invention peut être également employé pour d'autres applications telles que des dispositifs laser hybride III-V comprenant deux couches de contacts 281, 282 composé de matériaux différents. L'expression « III-V » vise, comme mentionné ci-dessus, des matériaux comprenant au moins un élément faisant partie des éléments des colonnes III et V de la classification périodique des éléments.

En bref, le procédé de l'invention peut présenter les avantages ci-dessous :

(1) La flexibilité de choix des matériaux et celle de conductivités désirées pour des dispositifs obtenus : l'invention permet de former deux couches métalliques composées de matériaux identiques ou différents, et de réaliser, par conséquent, deux couches de contact qui comprennent des compositions partiellement ou totalement différentes, ce qui améliore la flexibilité de choix des matériaux pour deux couches métalliques ainsi que celle des conductivités désirées pour deux couches de contact respectivement pour deux transistors de types différents.

(2) La flexibilité en termes de la densité des motifs et de dimension réduite des dispositifs.

(3) L'optimisation des paramètres de formation des deux couches métalliques pour un substrat donné : cet optimum sera différent selon des substrats de matériaux différents. Des caractéristiques telles que l'épaisseur et la rugosité des deux couches métalliques déposées sont également dépendantes de la couche superficielle du substrat employé sur laquelle elles sont déposées. De plus, l'invention est flexible en termes de matériaux à employer car les matériaux des couches métalliques sont moins dépendants du matériau de la couche superficielle du substrat employé.

(4) La flexibilité en termes de dépôts des couches métalliques dans des structures à fort aspect ratio (rapport de forme).

(5) La réduction de la consommation de matériaux des couches métalliques et par conséquent la simplification de la séquence de fabrication des dispositifs.

L'invention n'est pas limitée aux modes de réalisation précédemment décrits mais s'étend à tout mode de réalisation couvert par les revendications.

**Revendications**

1. Procédé de fabrication d'un dispositif microélectronique comportant, sur la base d'un substrat (112) :

   - une formation d'une première couche (201) d'un premier matériau semi-conducteur, sur une première zone d'une surface supérieure du substrat (112) ;
   - une formation d'une deuxième couche (202) d'un deuxième matériau semi-conducteur, sur une deuxième zone, distincte de la première zone, de la surface supérieure du substrat (112) ;

   comprenant, après la formation de la deuxième couche (202) :

   - une formation d'une première couche métallique (207a) au-dessus de la première couche (201) ;
   - une formation d'une première couche de contact (281) d'un premier composé intermétallique ou solution solide comprenant au moins une portion de la première couche (201) et au moins une portion de la première couche métallique (207a) ;
   - une formation d'une deuxième couche métallique (207b) au-dessus de la deuxième couche (202) ;
   - la formation d'une deuxième couche de contact (282) d'un deuxième composé intermétallique ou solution solide comprenant au moins une portion de ladite portion résiduelle et au moins une portion de la deuxième couche métallique (207b) ;

   le procédé étant **caractérisé en ce qu'**il comprend, entre la formation de la première couche de contact (281) et la formation de la deuxième couche métallique (207b) :

   - une formation d'une première couche sacrificielle (271a) par oxydation d'une portion supérieure de la première couche de contact (281), et d'une deuxième couche sacrificielle (271b) par oxydation d'une portion supérieure de la deuxième couche (202), l'épaisseur $e_1$ de la première couche sacrificielle (271a) étant plus importante que l'épaisseur $e_2$ de la deuxième couche sacrificielle (271b) ;
   - la réalisation d'un enlèvement de la totalité de la deuxième couche sacrificielle (271b) de sorte à exposer une portion résiduelle de la deuxième couche (202) et d'un enlèvement partiel de la première couche sacrificielle (271a) ;

   et **en ce que** la deuxième couche métallique (207b) est formée au-dessus de ladite portion résiduelle de la deuxième couche (202).

2. Procédé selon la revendication précédente dans lequel la formation des première et deuxième couches sacrificielles (271a, 271b) comprend la réalisation d'un traitement thermique.

3. Procédé selon la revendication précédente dans lequel le traitement thermique est réalisé lors d'une durée de 2 à 100 heures et à une température entre 700 degré (°C) et 1200 °C de sorte à former les première et deuxième couches sacrificielles (271a, 271b).

4. Procédé selon l'une quelconque des revendications précédentes comprenant, après la formation de la deuxième couche de contact (282), la réalisation d'un enlèvement total de la première couche sacrificielle (271a).

5. Procédé selon l'une quelconque des revendications précédentes 1 à 4 dans lequel les première et deuxième couches sacrificielles (271a, 271b) sont enlevées par attaque chimique.

**6.** Procédé selon l'une quelconque des revendications précédentes dans lequel les formations des première et deuxième couches de contact (281, 282) comprennent la réalisation d'un traitement thermique.

**7.** Procédé selon la revendication précédente dans lequel le traitement thermique est réalisé lors d'une durée de 10 à 600 secondes et à une température entre 150°C et 500°C de sorte à former les première et deuxième couches de contact (281, 282).

**8.** Procédé selon l'une quelconque des revendications précédentes 1 à 7 dans lequel la première couche métallique (207a) et la deuxième couche métallique (207b) sont en des matériaux différents.

**9.** Procédé selon l'une quelconque des revendications précédentes dans lequel le premier matériau semi-conducteur et le deuxième matériau semi-conducteur sont différents.

**10.** Procédé selon la revendication précédente dans lequel la première couche métallique (207a) est formée par dépôt sélectif en dehors de zones comprenant des zones diélectriques de la surface supérieure du substrat (112) et la deuxième couche (202) du deuxième matériau semi-conducteur.

**11.** Procédé selon l'une quelconque des revendications précédentes 9 ou 10 dans lequel la deuxième couche métallique (207b) est formée par dépôt sélectif en dehors de zones comprenant des zones diélectriques de la surface supérieure du substrat (112) et celles de la première couche sacrificielle (271a).

**12.** Procédé selon l'une quelconque des revendications précédentes 10 ou 11 dans lequel au moins l'une parmi les première et deuxième couches métalliques (207a, 207b) est formée par voie électrochimique non assistée.

**13.** Procédé selon l'une quelconque des revendications précédentes dans lequel l'épaisseur de la première couche métallique (207a) et celle de la deuxième couche métallique (207b) sont supérieures à 5 nm.

**14.** Procédé selon l'une quelconque des revendications précédentes dans lequel au moins l'un parmi les premier et deuxième matériaux semi-conducteurs est choisi parmi des matériaux suivant : le silicium, une solution solide de silicium contenant du carbone, une solution solide de silicium ou de germanium, le germanium, le silicium-germanium, des matériaux composés d'éléments des colonnes III et V du tableau périodique standard des éléments.

**15.** Procédé selon la revendication 14 dans lequel les premier et deuxième matériaux semi-conducteurs sont choisis parmi des matériaux suivant : le silicium, une solution solide de silicium contenant du carbone, une solution solide de silicium ou de germanium.

**16.** Procédé selon la revendication 14 dans lequel les premier et deuxième matériaux semi-conducteurs sont choisis parmi des matériaux composés d'éléments des colonnes III et V du tableau périodique standard des éléments.

**Patentansprüche**

**1.** Herstellungsverfahren einer mikroelektronischen Vorrichtung, umfassend, auf der Basis eines Substrats (112):

- ein Bilden einer ersten Schicht (201) eines ersten Halbleitermaterials auf einem ersten Bereich einer oberen Oberfläche des Substrats (112);
- ein Bilden einer zweiten Schicht (202) eines zweiten Halbleitermaterials auf einem zweiten Bereich, verschieden von dem ersten Bereich, der oberen Oberfläche des Substrats (112);

beinhaltend, nach dem Bilden der zweiten Schicht (202):

- ein Bilden einer ersten metallischen Schicht (207a) über der ersten Schicht (201);
- ein Bilden einer ersten Kontaktschicht (281) aus einer ersten intermetallischen Verbindung oder festen Lösung, beinhaltend mindestens einen Abschnitt der ersten Schicht (201) und mindestens einen Abschnitt der ersten metallischen Schicht (207a);
- ein Bilden einer zweiten metallischen Schicht (207b) über der zweiten Schicht (202);
- das Bilden einer zweiten Kontaktschicht (282) aus einer zweiten intermetallischen Verbindung oder festen Lösung, beinhaltend mindestens einen Abschnitt des verbleibenden Abschnitts und mindestens einen Abschnitt der zweiten metallischen Schicht (207b);

wobei das Verfahren **dadurch gekennzeichnet ist, dass** es zwischen dem Bilden der ersten Kontaktschicht (281) und dem Bilden der zweiten metallischen Schicht (207b) beinhaltet:

- ein Bilden einer ersten Opferschicht (271a) durch Oxidation eines Abschnitts eines oberen Abschnitts der ersten Kontaktschicht (281), und einer zweiten Opferschicht (271b) durch Oxidation eines oberen Abschnitts der zweiten Schicht (202), wobei die Dicke $e_1$ der ersten Opferschicht (271a) größer ist als die Dicke $e_2$ der zweiten Opferschicht (271b);
- die Durchführung eines Entfernens der Gesamtheit der zweiten Opferschicht (271b), sodass ein verbleibender Abschnitt der zweiten Schicht (202) freigelegt wird, und eines teilweisen Entfernens der ersten Opferschicht (271a);

und dadurch, dass die zweite metallische Schicht (207b) über dem verbleibenden Abschnitt der zweiten Schicht (202) gebildet wird.

2. Verfahren nach dem vorstehenden Anspruch, wobei das Bilden der ersten und zweiten Opferschicht (271a, 271b) die Durchführung einer thermischen Behandlung beinhaltet.

3. Verfahren nach dem vorstehenden Anspruch, wobei die thermische Behandlung während einer Dauer von 2 bis 100 Stunden und bei einer Temperatur zwischen 700 Grad (°C) und 1200 °C durchgeführt wird, sodass die erste und zweite Opferschicht (271a, 271b) gebildet werden.

4. Verfahren nach einem der vorstehenden Ansprüche, beinhaltend, nach dem Bilden der zweiten Kontaktschicht (282), die Durchführung einer Gesamtentfernung der ersten Opferschicht (271a).

5. Verfahren nach einem der vorstehenden Ansprüche 1 bis 4, wobei die erste und zweite Opferschicht (271a, 271b) durch chemischen Angriff entfernt werden.

6. Verfahren nach einem der vorstehenden Ansprüche, wobei die Bildungen der ersten und zweiten Kontaktschicht (281, 282) die Durchführung einer thermischen Behandlung beinhalten.

7. Verfahren nach dem vorstehenden Anspruch, wobei die thermische Behandlung während einer Dauer von 10 bis 600 Sekunden und bei einer Temperatur zwischen 150°C und 500°C durchgeführt wird, sodass die erste und zweite Kontaktschicht (281, 282) gebildet werden.

8. Verfahren nach einem der vorstehenden Ansprüche 1 bis 7, wobei die erste metallische Schicht (207a) und die zweite metallische Schicht (207b) aus unterschiedlichen Materialien bestehen.

9. Verfahren nach einem der vorstehenden Ansprüche, wobei das erste Halbleitermaterial und das zweite Halbleitermaterial unterschiedlich sind.

10. Verfahren nach dem vorstehenden Anspruch, wobei die erste metallische Schicht (207a) durch selektives Abscheiden außerhalb von Bereichen, die dielektrische Bereiche der oberen Oberfläche des Substrats (112) beinhalten, und der zweiten Schicht (202) des zweiten Halbleitermaterials gebildet wird.

11. Verfahren nach einem der vorstehenden Ansprüche 9 oder 10, wobei die zweite metallische Schicht (207b) durch selektives Abscheiden außerhalb der Bereiche, die dielektrische Bereiche der oberen Oberfläche des Substrats (112) beinhalten, und jener der ersten Opferschicht (271a) gebildet wird.

12. Verfahren nach einem der vorstehenden Ansprüche 10 oder 11, wobei mindestens eine aus der ersten und zweiten metallischen Schicht (207a, 207b) durch nicht assistierten elektrochemischen Weg gebildet werden.

13. Verfahren nach einem der vorstehenden Ansprüche, wobei die Dicke der ersten metallischen Schicht (207a) und jene der zweiten metallischen Schicht (207b) oberhalb von 5 nm liegen.

14. Verfahren nach einem der vorstehenden Ansprüche, wobei mindestens eins aus dem ersten und zweiten Halbleitermaterial ausgewählt wird aus den folgenden Materialien: Silicium, einer festen Lösung von Silicium, die Kohlenstoff enthält, einer festen Lösung von Silicium oder von Germanium, Germanium, Silicium-Germanium, Materialien, die aufgebaut sind aus Elementen der Gruppen III und V des Standardperiodensystems der Elemente.

15. Verfahren nach Anspruch 14, wobei das erste und zweite Halbleitermaterial ausgewählt werden aus den folgenden Materialien: Silicium, einer festen Lösung von Silicium, die Kohlenstoff enthält, einer festen Lösung von Silicium oder von Germanium.

16. Verfahren nach Anspruch 14, wobei das erste und zweite Halbleitermaterial ausgewählt werden aus Materialien, die aufgebaut sind aus Elementen der Gruppen III und V des Standardperiodensystems der Elemente.

**Claims**

1. A method for manufacturing a microelectronic device including, on the basis of a substrate (112):

   - forming a first layer (201) of a first semiconductor material, on a first area of an upper surface of the substrate (112);
   - forming a second layer (202) of a second semiconductor material, on a second area, distinct from the first area, of the upper surface of the substrate (112); comprising, after forming the second layer (202):
   - forming a first metal layer (207a) above the first layer (201);
   - forming a first contact layer (281) of a first intermetallic compound or solid solution comprising at least one portion of the first layer (201) and at least one portion of the first metal layer (207a);
   - forming a second metal layer (207b) above the second layer (202);
   - forming a second contact layer (282) of a second intermetallic compound or solid solution comprising at least one portion of said residual portion and at least one portion of the second metal layer (207b);

   the method being **characterised in that** it comprises, between forming the first contact layer (281) and forming the second metal layer (207b):

   - forming a first sacrificial layer (271a) by oxidation of an upper portion of the first contact layer (281), and a second sacrificial layer (271b) by oxidation of an upper portion of the second layer (202), the thickness $e_1$ of the first sacrificial layer (271a) being greater than the thickness $e_2$ of the second sacrificial layer (271b);
   - carrying out a removal of the entire second sacrificial layer (271b) so as to expose a residual portion of the second layer (202) and a partial removal of the first sacrificial layer (271a);

   and **in that** the second metal layer (207b) is formed over said residual portion of the second layer (202).

2. The method according to the preceding claim, wherein the formation of the first and second sacrificial layers (271a, 271b) comprises carrying out a heat treatment.

3. The method according to the preceding claim wherein the heat treatment is carried out for a period of 2 to 100 hours and at a temperature between 700 degrees (°C) and 1200 °C so as to form the first and second sacrificial layers (271a, 271b).

4. The method according to any one of the preceding claims comprising, after forming the second contact layer (282), carrying out a total removal of the first sacrificial layer (271a).

5. The method according to any one of the preceding claims 1 to 4 wherein the first and second sacrificial layers (271a, 271b) are removed by etching.

6. The method according to any one of the preceding claims wherein the formations of the first and second contact layers (281, 282) comprise performing a heat treatment.

7. The method according to the preceding claim wherein the heat treatment is carried out for a period of 10 to 600 seconds and at a temperature between 150°C and 500°C so as to form the first and second contact layers (281, 282).

8. The method according to any one of the preceding claims 1 to 7 wherein the first metal layer (207a) and the second metal layer (207b) are made of different materials.

9. The method according to any one of the preceding claims wherein the first semiconductor material and the second semiconductor material are different.

10. The method according to the preceding claim wherein the first metal layer (207a) is formed by selective deposition outside areas comprising dielectric areas of the upper surface of the substrate (112) and the second layer (202) of the second semiconductor material.

11. The method according to any one of the preceding claims 9 or 10 wherein the second metal layer (207b) is formed by selective deposition outside areas comprising dielectric areas of the upper surface of the substrate (112) and those of the first sacrificial layer (271a).

12. The method according to any one of the preceding claims 10 or 11 wherein at least one of the first and second metal layers (207a, 207b) is formed by electroless deposition.

13. The method according to any one of the preceding claims wherein the thickness of the first metal layer (207a) and that of the second metal layer (207b) are greater than 5 nm.

14. The method according to any one of the preceding claims, wherein at least one of the first and second semiconductor materials is selected from the following materials: silicon, a solid solution of silicon containing carbon, a solid solution of silicon or germanium, germanium, silicon germanium, materials composed of elements from columns III and V of the standard periodic table of the elements.

15. The method according to claim 14 wherein the first and second semiconductor materials are selected from the following materials: silicon, a solid solution of silicon containing carbon, a solid solution of silicon or germanium.

16. The method according to claim 14 wherein the first and second semiconductor materials are selected from materials composed of elements of columns III and V of the standard periodic table of the elements.

| Formation d'une première couche d'un premier matériau semi-conducteur | 210 |

| Formation d'une deuxième couche d'un deuxième matériau semi-conducteur différent du premier matériau semi-conducteur | 220 |

Préparation d'une surface supérieure de la structure obtenue après la réalisation de l'étape 220 :

| Nettoyage de la surface supérieure de la structure obtenue | 310 |

| Sensibilisation de la surface supérieure de la structure obtenue | 320 |

230

| Activation de la surface supérieure de la structure obtenue | 330 |

| Rinçage post-activation de la surface supérieure de la structure obtenue | 340 |

| Formation d'une couche métallique au dessus de la première couche préférentiellement par voie électrochimique non assistée | 240 |

| Formation de première couche de contact en réalisant préférentiellement un traitement thermique | 250 |

**FIGURE 1a**

250

Formation des première et deuxième couches sacrificielles par oxydation — 260

Enlèvement total de la deuxième couche sacrificielle et enlèvement partiel de la première couche sacrificielle — 270

Préparation d'une surface supérieure de la structure obtenue après la réalisation de l'étape 260 — 230

Formation d'une deuxième couche métallique au dessus d'une portion résiduelle de la deuxième couche 202 (préférentiellement par voie électrochimique non assistée) — 280

Formation d'une deuxième couche de contact en réalisant préférentiellement un traitement thermique — 290

Enlèvement des portions résiduelles de la deuxième couche métallique et/ou des portions de la deuxième couche de contact situées au dessus des STI et de la première couche sacrificielle — 295

Enlèvement de la première couche sacrificielle — 300

**FIGURE 1b**

FIG. 2a

FIG. 2b

FIG. 2c

202    239 281    201
124b    124a
410b    410a
146
114
113

**FIG. 2d**

202 271b    239 271a    281 201
124b    124a
410b    410a
146
114
113

**FIG. 2e**

202    239 271a    281 201
124b    124a
410b    410a
146
114
113

**FIG. 2f**

**FIG. 2g**

**FIG. 2h**

**FIG. 2i**

**EP 2 894 665 B1**

**Documents brevets cités dans la description**

- US 2005156208 A1
- US 2006121664 A1